# EUROPEAN PATENT APPLICATION

(11) **EP 0 843 352 A1**
(43) Date of publication of application: **20.05.1998**
(21) Application number: 96480106.2
(22) Date of filing: 15.11.1996
(51) Int. Cl.: H01L 21/58

(54) **Method for removing a semiconductor chip bonded to a wire-bonded multichip module**

(71) Applicant: MONTPELLIER TECHNOLOGIES, 34055 Montpellier Cédex 1 (FR)
(72) Inventor: Morazzani, Marc, 34090 Montpellier (FR)
(74) Representative: Klein, Daniel Jacques Henri

(57) **Abstract**

Method for removing a selected semiconductor chip (11) from an array of chips adhesively attached to the substrate (10) of a wire-bonded MCM module comprising the steps of: placing the substrate (10) on a hot plate (14) and clamping it thereon, applying a small amount of a quick curing glue onto the exposed surface of the said selected chip to be removed to form a glob (17) that also encapsulates the connecting wires (13), aligning a stud (16) with said chip, then lowering it to contact the glob atop the chip, heating to a first temperature (T1) to cure the glue material providing thereby a strong bond between the stud extremity and the chip, heating to a second temperature (T2) that is substantially above the glass transition temperature of the adhesive material to reduce the adhesion between the chip and the substrate, and finally, pulling the the stud at a controlled speed to release the chip from the substrate without damaging the surrounding chips of the array.

## Description

### FIELD OF INVENTION

The present invention relates generally to semiconductor chip packaging and more particularly to a method for removing a determined semiconductor chip from the surface of an electronic module without harm for the surrounding chips. The proposed method finds extensive applications in the repair/rework of costly multichip modules of the wire-bonded type which incorporate up to 100 semiconductor chips adhesively attached to an insulating substrate. The method of the present invention is relatively simple, easy to make and inexpensive.

### BACKGROUND OF THE INVENTION

In wire-bonding applications, the electronic device, typically a silicon chip, is usually attached to a surface of an insulating substrate, typically a multilayer structure made of ceramic, glass or organic material by a conductive or non conductive adhesive. After chip attachment, the I/O pads of the chip are commonly connected to conductive lands or conductors formed at the surface of the substrate by the means of metal wires, referred to as connecting wires hereinbelow to provide the desired electrical interconnection scheme. Next, the substrate is tested and if found "good", it is encapsulated to form the module. Finally, the fully assembled module is tested again to ensure its total operability. A single chip module (SCM) that fails this test, is usually scrapped, because generally it is not worthwhile to save the substrate as its cost is low compared to the cost of rework. On the contrary, in the case of a multichip module (MCM), which incorporates a number of chips, scrapping would mean to loose not only a complex multilayer substrate but also all the remaining chips which may be good. Because chips are generally expensive products, it would result a significant loss of money.

To avoid the scrapping of such a MCM module, it is therefore highly desirable to develop a method for selectively removing the defective chip and to replace it by a good one without detrimentally affecting the neighbouring chips. The problem addressed by the present invention is that of providing a method for removing a defective chip adhesively attached to the substrate of a wire-bonded MCM module without leaving adhesive residues (a possible source of contamination) and without causing harm to the surrounding chips. It is to be noted that this method is not limited to wire-bonded MCM modules. It also encompasses any type of packaging where the chips are adhesively attached to the substrate but which are not based upon the wire-bonding technique described above, for instance, the so-called polymer flip-chip where the interconnection is performed by conductive polymer bumps.

A few state of the art methods aim to perform this removal operation in acceptable conditions. According to the chip push-off technique, the ceramic substrate is heated and the chip is released by some mechanical means such as a shear tool or the like to provide the necessary shearing force. Unfortunately, this approach generally produces cracks in the silicon substrate that are a yield detractor. Moreover, it produces adhesive residues that are very difficult to eliminate and therefore are a potential source of contamination for the other chips. Finally, this technique works only with small size chips (less than 5x5 mm2 but as low as 1x1 mm2) but not with larger chips. Another technique consists in a chemical attack of the adhesive. A solvent is applied to the adhesive for total removal. The chip may then be easily pushed off or pulled. This process which requires a chemical compound well adapted to the specific adhesive used for the chip attachment may also affect the attachment of the neighbouring chips. Yet another technique is based on the use of a thermoplastic resin. These materials have the property to soften when heated up, allowing the chips to be easily removed. A major drawback of this process is that the MCM module can no longer be used for high reliability applications which often require gold connecting wires. The bonding of gold wires mandatorily requires to heat the substrate while the wire are ultrasonically bonded. Heating which reduces the adhesion between the chip and the substrate renders the bonding operation quite difficult and unreliable. Finally, recent studies have shown interest in a family of adhesive materials that have a very low glass transition temperature (Tg), typically less than 25°C, compared to about 100°C for the most commonly used epoxies. When heated above this temperature, chip removal can be performed. In the present case, such materials are not adequate for high reliability applications, still because gold wires cannot be used. On the other hand, some attempts have been made to bond a good rated chip onto the bad one, avoiding thereby the need to remove it. This technique is often not acceptable because it increases the height of the MCM module which should be maintained to a minimum value in most applications.

Another related problem, common to all the above described prior art techniques, is the removal of the wires. To that end, an extra step is required which is generally performed by hands with tweezers or the like. A specific tool has also be presented a few years ago wherein the wires remaining at the surface of the substrate were blown-out by pulsating jets of air on the substrate surface.

### SUMMARY OF THE PRESENT INVENTION

It is therefore a primary object of the present invention to provide an improved method for removing a semiconductor chip which is adhesively bonded to the substrate surface of an electronic module that is simple, easy to make and inexpensive.

It is another object of the present invention to provide an improved method that is capable to remove a determined semiconductor chip from the surface of a wire-bonded MCM module without detrimentally affecting the neighbouring chips.

It is another object of the present invention to provide an improved method for removing a semiconductor chip which is adhesively bonded to the substrate surface of a wire-bonded MCM module that can be used either for large or small chips in a manufacturing environment.

It is still another object of the present invention to provide an improved method for removing a semiconductor chip which is adhesively bonded to the substrate surface of a MCM module which does not require a specific step to remove the connecting wires remaining at the substrate surface for chip site dressing.

Reworking wire-bonded MCM modules which house a number of expensive semiconductor chips is necessary to replace defective chips by good ones or for engineering changes. According to the present invention, there is provided a method for removing a defective chip from the site of the substrate where it is adhesively attached. Said method involves the steps of: coupling a stainless steel stud to the top surface of the selected chip, typically by means of a quick curing glue that also coats the wires, curing the glue to ensure a firm bond between the stud and the chip, heating the substrate to reduce adhesion between the chip and the substrate, and finally, pulling-up the stud to remove the chip. During this step, the bonding wires are properly removed because they are trapped in the cured glue. As a matter of fact, the connecting wires break at the substrate level, so that there is no need any longer for a specific wire removal operation. A standard chip placement process, typically used in MCM module fabrication, can be then used to repopulate the substrate.

### BRIEF DESCRIPTION OF THE DRAWINGS

The novel features believed to be characteristic of this invention are set forth in the appended claims. The invention itself, however, as well as other objects and advantages thereof, may be best understood by reference to the following detailed description of an illustrated preferred embodiment to be read in conjunction with the accompanying drawings, in which:
Fig. 1A is a fragmented schematic diagram of a wire-bonded MCM module incorporating large semiconductor chips to illustrate a first preferred embodiment of the present invention.
Fig. 1B is a fragmented schematic diagram of a wire-bonded MCM module incorporating small semiconductor chips to illustrate a second preferred embodiment of the present invention.
Fig. 2 is the schematic flow-chart of a standard packaging process including the method steps of removing a semiconductor chip from a wire-bonded MCM module according to the present invention.

### DESCRIPTION OF THE PREFERRED EMBODIMENTS

The method of the present invention is directed to electronic modules and more particularly to wire-bonded MCM modules wherein the chips are adhesively attached to the insulating substrate. Although, two variants of the method will be described hereafter, one for the large chips (more than 5x5 mm2), the other for smaller chips, they are both based on the thermo-mechanical properties of current adhesives known to date. In addition, they substantially require the same operating step sequence and the same tooling. For sake of illustration, the following description will be made by reference to a wire-bonded MCM module. The starting material consists of the insulating substrate (possibly an uncapped MCM module). First of all, a stud is coupled to the top surface of the selected chip, typically by means of a quick curing glue that also coats the connecting wires. Then, the glue is cured for setting. The cured glue provides a very strong bond between the stud and the chip. Now, the substrate is heated to reduce adhesion between the chip and the substrate. Finally, the stud is pulled-up at a controlled speed to release the chip. During this step, the connecting wires are totally removed with the chip. This is quite unexpected, because only the portion of said wires at the proximity of the chip pads are trapped in the cured glue. As a matter of fact, they break at the substrate level, so that there is no need any longer for a specific wire removal operation. An essential aspect of the present invention lies in the selection of the glue material. First, it must have higher mechanical strength in temperature than the adhesive material and its glass transition temperature is preferably greater than the glass transition temperature of the adhesive material. Typically, the substrate is heated at a temperature which is between these glass transition temperatures. The higher this temperature, the easier the chip removal and the fewer are the adhesive residues. However, this temperature must be compatible with the other process parameters.

### Removal of large chips.

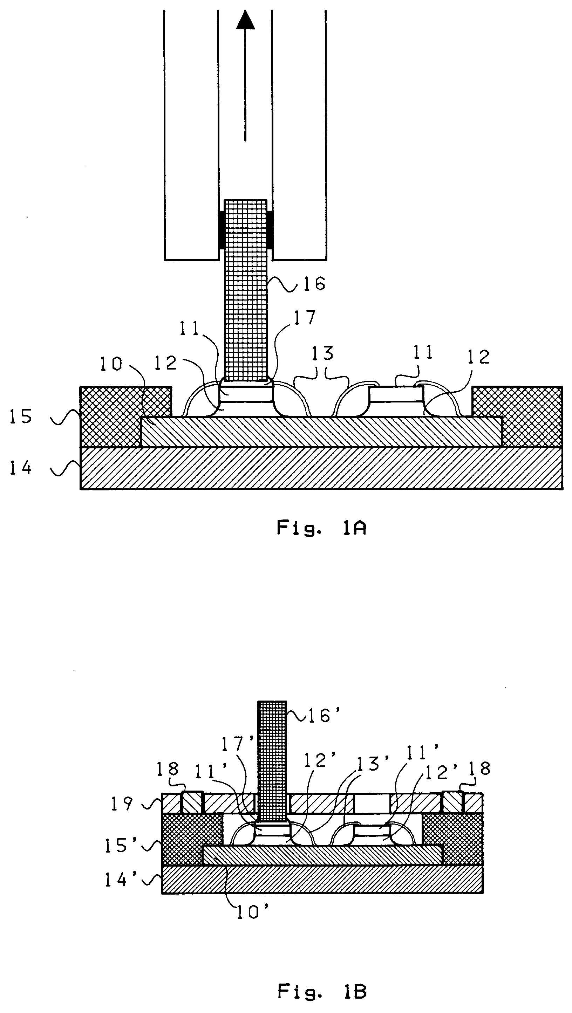

First of all, the cap (if any) of the wire-bonded MCM module is removed to expose the substrate surface. As depicted in Fig. 1A, the substrate, typically a multilayer ceramic or organic structure referenced 10, carries a plurality of silicon chips 11 forming an array. Chips 11 are attached to the substrate by a layer 12 of an adhesive material. Experimental results given hereinbelow have been conducted with ABLESTIK 84-1-LMI, a product commercially available from ABLESTIK, Rancho Dominguez, CA, USA that has a glass transition temperature Tg1 equal to 103°C. Metallic wires 13 provide the desired electrical connections between the I/O pads of the chips and the conductive lands formed at the substrate surface. The module 10 is placed over a hot plate 14 and firmly affixed thereto by means of a clamping device, typically a frame 15. Preferably, the hot plate 14 is part of a pull machine (for instance, model 1122 sold by INSTRON LTD, Buckinghamshire, UK). A pulling device, is schematically represented in Fig. 1A by a stud 16 mounted on a pull head. The temperature of the hot plate 14 can be accurately controlled and regulated as standard. A small amount of a quick curing glue is applied over the chip top surface and forms a glob 17 thereon. For instance, a cyanate-ester based glue such as the JM7000 sold by JOHNSON MATTHEY, London, UK, is adequate in all respects. Its glass transition temperature Tg2 is equal to 240°C. In this case, the thickness of the glue is from about 10 µm to about 150 µm and is preferably equal to 100 µm. The chip 11 selected for being removed is aligned with the stud 16 e.g. by means of an X/Y table supporting the hot plate 14. The stud 16 is lowered to enter into contact with the glob 17. The hot plate 14 is raised to a temperature T1 (cure temperature) and a duration sufficient to fully cure the glue forming glob 17 providing thereby a very strong bond between the stud 16 extremity and the chip 11. A temperature T1 equals to 160îC is adequate in that respect. Preferably, the stud 16 is obtained by sawing a stainless steel rod into 3 cm long pieces. The section of the rod is in the particular case of such wire-bonded MCM modules slightly smaller than the size of the chip 11 by about 1 mm over the chip periphery. For instance, a 5x9 mm2 section stud is used for a 6x10 mm2 chip. This clearance allows to form a fillet of glue all around the stud 16 extremity at the chip periphery that coats the wires. The surface of the stud 16 that comes into contact with the top or upward surface of the chip 11 is preferably sand-blasted to improve adhesion therewith.

Now, the hot plate 14 is then raised to a temperature T2 (removal temperature) at least equal but preferably above the glass transition temperature Tg1 of the adhesive material to reduce the coupling between the chip 11 and the substrate 10. A temperature T2 equal to 180°C is adequate. As soon as the substrate has reached this temperature, the pull cycle may start. The stud 16 is pulled up at a well determined speed to break the bond between the chip and the substrate without damage. Experiments have shown that pulling speed shall be less than 10 mm/mn. Higher speeds would increase the risk of cracks in the silicon chip. Unexpectedly, connecting wires are broken at the substrate level at the very proximity of the metal lands, thus leaving a clean surface which does not require any chip site dressing.

### Removal of small chips

For small chips, usage of a pull machine is no longer mandatory. Designing a stud matching the small chip size could become an expensive process. Thus, the manual removal method described below in conjunction with Fig. 1B is recommended, but the automatic tooling described by reference to Fig. 1A could still be employed. The other operating conditions are substantially the same. Similar elements referenced in Fig. 1A will bear the same reference but will be differentiated by a prime. Now turning to Fig.1B, the frame 15' is provided with pins 18 that are adapted to receive a mask 19 that has the desired hole pattern corresponding to the chip array. In this case, the stud 16 simply consists of a small tube referenced 16'. An annular stud is preferred in this context because it increases the contacting surface between the stud and the glue material. To that purpose, one may use dispense needles, for in stance, models GP sold by EFD Inc., East Providence, RI, USA, with internal diameters ranging from .1 to 1.5 mm, that have demonstrated their capability of removing chips having sizes comprised between 1x1 mm2 and 5x5 mm2.

Irrespective the variant, once the chip is separated from the substrate, no further step is required for dressing or cleaning the chip site, because the wires trapped in the cured glue are properly removed. However, should any adhesive residues remain at the end of the removal process, they would be eliminated with a vacuum scrapper.

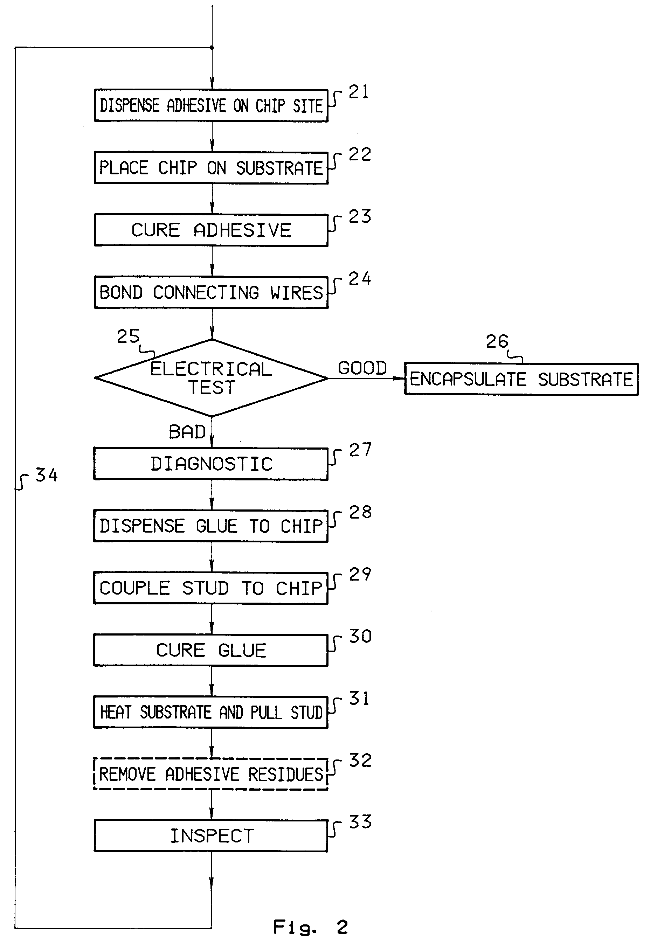

The basic steps describing the standard chip attachment process and the chip removal process pursuant to the present invention are schematically illustrated by flow-chart 20 in Fig. 2. Now turning to Fig. 2, the adhesive material is first dispensed at the surface of the substrate at the chip site (box 21), then the chip is correctly placed thereon (box 22). The adhesive is cured (box 23). Next, the wires are bonded to the I/O pads and the metal lands (box 24). The substrate is submitted to electrical tests to determine its operability. If tested "good", the substrate is encapsulated (box 26). If some chip is tested "bad", a diagnostic of the failure is per formed (box 27). The above described procedure is standard. Now, the steps of chip removal according to the present invention will be described. A glob of glue is dispensed on the top surface of the defective chip (box 28). The stud is lowered and firmly applied onto the glob of glue (box 29). Next, the glue is cured (box 30). During this step, the wires are encapsulated in the glue. Finally, the substrate is heated and the stud is lifted up (box 31). The adhesive residues (if any) are removed (box 32) and the substrate is inspected (box 33). The reworked substrate is then submitted again to the steps described above for a new pass as illustrated in Fig. 2 by loop 34.

Since there is a very high cost in a completely assembled wire-bonded MCM module, it is therefore highly desirable to be able to repair/rework it by removing a defective chip and replace it by an operative one rather than scrapping the whole MCM module. In that respect, the method of breaking the strong adhesive bond between the chip and the substrate according to the present invention is really worthwhile. The method can be accomplished either with a simple hand tool or with an automatic tooling.

## Claims

1. Method for removing a selected semiconductor chip (11) adhesively attached to the substrate (10) of an electronic module comprising the steps of:
placing the substrate (10) on a plate (14) and clamping it thereon;
applying a small amount of a quick curing glue onto the exposed surface of the said selected chip to be removed to form a glob (17);
aligning a stud (16) with said chip, then lowering it to contact the glob atop the chip;
heating the substrate to a first temperature (T1) to cure the glue material providing thereby a strong bond between the stud extremity and the chip;
heating the substrate to a second temperature (T2) to reduce the adhesion between the chip and the substrate; and,
pulling the stud to release said selected chip from the substrate.

2. The method of claim 1 wherein said electronic module is a MCM module of the wire-bonded type wherein connecting wires ensure the electrical interconnection between the chip pads and the metal lands formed on the substrate surface.

3. The method of claim 2 wherein the glue also encapsulates the connecting wires (13).

4. The method of claim 3 wherein the stud section is less than the surface of the chip to produce a fillet of glue at the pheriphery of the chip for connecting wire encapsulation purposes.

5. The method of any above claim wherein the adhesive material is an epoxy material and the glue material is a cyanate-ester based material.

6. The method of claim 5 wherein the second temperature is equal or greater than the glass transition temperature of the epoxy material.

7. The method of claim 6 wherein said first and second temperatures T1 and T2 are equal to about 160°C and 180°C respectively.

8. The method of claim 6 wherein said first and second temperatures T1 and T2 are equal to about 160°C.

9. The method of any above claim wherein said stud is obtained by sawing a stainless steel rod.

10. The method of claim 9 wherein the extremity of the stud that is adjacent to the chip is sand-blasted for better adhesion.

11. The method of any above claim 1 to 8 wherein said stud consists of a dispense needle to adapt to small chips having a size in the range of 1x1 to 5x5 mm2.

12. The method of any above claim wherein the pull speed is in the range of 10 mm/mn.
